Europäisches Patentamt

European Patent Office

Office européen des brevets

(19)

(11) **EP 0 886 382 A1**

(12) **DEMANDE DE BREVET EUROPEEN**

(43) Date de publication:
23.12.1998 Bulletin 1998/52

(51) Int. Cl.$^6$: **H03M 1/00**, G05F 3/22

(21) Numéro de dépôt: 98201890.5

(22) Date de dépôt: 08.06.1998

(84) Etats contractants désignés:
AT BE CH CY DE DK ES FI FR GB GR IE IT LI LU
MC NL PT SE
Etats d'extension désignés:
AL LT LV MK RO SI

(30) Priorité: 17.06.1997 FR 9707512

(71) Demandeur:
Koninklijke Philips Electronics N.V.
5621 BA Eindhoven (NL)

(72) Inventeur: **Gandy, Philippe**
75008 Paris (FR)

(74) Mandataire: **Caron, Jean**
**Société Civile S.P.I.D.**
**156, Boulevard Haussmann**
**75008 Paris (FR)**

(54) **Convertisseur analogique/numérique.**

(57)  Le circuit, alimenté entre une source de tension haute (VCC) et une source de tension basse (masse), contient un convertisseur analogique/numérique (ADC) muni d'une échelle de résistances (RL) connectée entre une borne de sommet (Vtop) une borne de pied (Vbot) pour fournir une série de tensions de référence.

Selon l'invention, ce circuit est muni d'un montage générateur de polarisation constitué par une résistance (Rmid) reliée d'un côté à la source de tension d'alimentation et de l'autre côté à une source de courant de référence (Ip0), et de moyens d'auto-régulation (A2) pour commander un élément d'impédance variable (T5) intercalé entre la connexion (Vbot) de pied de l'échelle et la masse, moyens propres à réguler la tension (FS) aux bornes de l'échelle de résistances.

Applications : imagerie médicale, oscilloscopes, communication numérique, notamment télévision.

**Description**

La présente invention concerne un circuit intégré, destiné à être alimenté entre une source de tension haute et une source de tension basse, muni de sources de courant de référence et contenant un convertisseur analogique/numérique muni d'une échelle de résistances connectée entre une borne dite de sommet une borne dite de pied pour fournir une série de tensions de référence, la borne de pied étant reliée à la source de tension basse via un élément à tension variable.

Un tel circuit est utilisé lorsque l'on cherche à quantifier une tension analogique, par exemple en imagerie médicale, dans le domaine des oscilloscopes, de la communication numérique, notamment en télévision.

Un convertisseur analogique/numérique tel que mentionné ci-dessus est connu de l'abrégé de brevet JP-A-58-25717. Dans le convertisseur analogique/numérique décrit par ce document, la borne de pied est reliée à la source de tension basse via un élément introduisant une tension de décalage variable, et pour prévenir l'influence de la fluctuation de cette tension de décalage, la tension haute est produite au moyen d'une source de tension fixe connectée à la borne de pied.

Un objet de l'invention est d'éviter que la conversion soit faussée si la tension haute ou les sources de courant varient.

A cet effet, le circuit est muni d'un montage générateur de polarisation intercalé entre la source de tension haute et la borne de sommet, et de moyens d'auto-régulation pour commander l'élément à tension variable de façon à réguler la tension aux bornes de l'échelle de résistances.

Avantageusement, les moyens d'auto-régulation comprennent un comparateur pour comparer une tension représentant la tension aux bornes de l'échelle de résistances avec la tension sur une borne d'une résistance dont l'autre borne est connectée à la borne de sommet et qui est traversée par le courant d'une source de courant de référence.

Ainsi, le gain de la conversion analogique/numérique est maintenu constant.

De préférence, la dite tension représentant la tension aux bornes de l'échelle de résistances est prélevée en un point intermédiaire de l'échelle de résistances.

Avantageusement, le montage générateur de polarisation comprend une résistance reliée d'un côté à la source de tension haute et de l'autre côté à une source de courant de référence.

Ainsi la tension correspondant à la pleine échelle du convertisseur peut être recopiée de celle obtenue dans un circuit amplificateur d'entrée, les résistances et sources de tension y étant de même type.

Avantageusement, le montage générateur de polarisation comprend une diode en série avec la résistance.

Ainsi la tension correspondant à la pleine échelle du convertisseur varie avec la température comme celle d'un circuit amplificateur d'entrée.

Dans un mode de réalisation particulier, le montage générateur de polarisation est muni en outre d'un amplificateur de sortie.

Avantageusement, le dit amplificateur de sortie comprend un amplificateur opérationnel suivi d'un transistor à effet de champ, le tout étant monté en gain unité.

Ainsi, le potentiel correspondant à la pleine échelle du convertisseur peut s'approcher très près de la tension haute.

Ces aspects de l'invention ainsi que d'autres aspects plus détaillés apparaîtront plus clairement grâce à la description suivante d'un mode de réalisation constituant un exemple non limitatif.

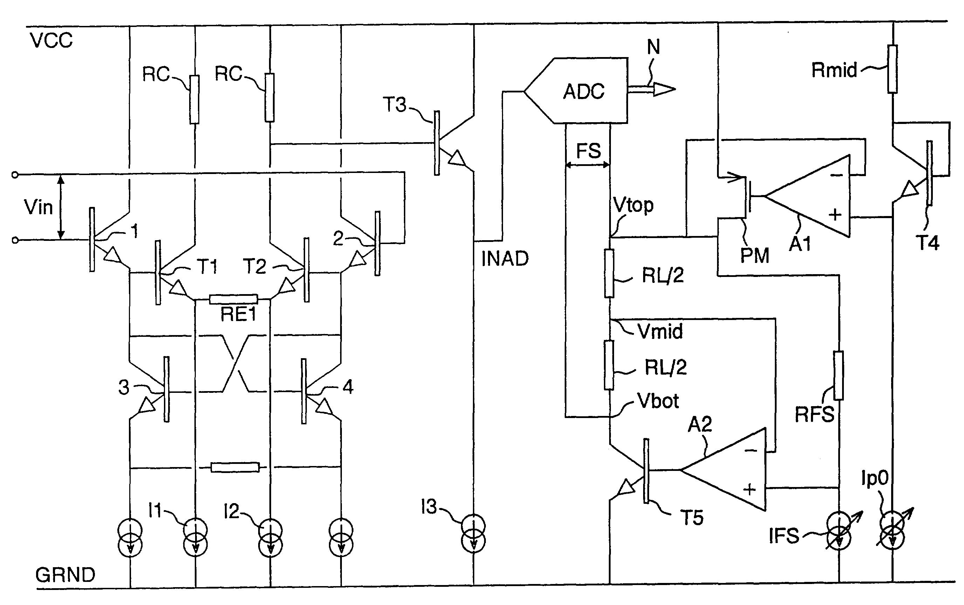

La figure unique représente schématiquement un circuit qui comprend un étage d'entrée suivi d'un convertisseur analogique/numérique.

Le circuit représenté par la figure est alimenté entre une source de tension d'alimentation dite tension haute VCC et une source de tension basse GRND, ici la masse. La tension d'entrée Vin est appliquée à un étage d'entrée différentiel à deux transistors 1, 2 symétriques, de type NPN, montés en suiveurs. Les émetteurs de ces transistors sont reliés chacun à une source de courant de référence via le trajet principal de courant d'un transistor respectivement 3, 4. La base du transistor 3 est reliée au collecteur du transistor 4, et réciproquement. Cet étage alimente un autre montage différentiel constitué par deux transistors de type NPN T1 et T2 montés avec chacun une charge de collecteur RC, dont les émetteurs sont reliés l'un à l'autre par une résistance RE1, et qui sont alimentés chacun par une source de courant de référence respectivement I1, I2. L'ensemble comprenant les transistors 1 à 4 ainsi que T1, T2 est connu en soi et ne nécessite pas de plus ample description.

Ces étages sont suivis d'un transistor NPN T3 monté en suiveur et chargé par une source de courant de référence I3. Le signal issu de cet étage T3 est appliqué à l'entrée INAD d'un convertisseur analogique/numérique ADC, qui fournit un signal converti sous forme numérique, à N bits.

Le convertisseur analogique/numérique ADC comporte, de façon habituelle, une échelle de résistances destinée à fournir une série de diverses tensions de référence, chacune étant prise au point commun de deux résistances successives de l'échelle, et comparée au signal d'entrée au moyen d'un comparateur. Ceci étant bien connu en soi n'a pas été représenté pour simplifier la figure.

L'échelle de résistances comprend ici deux moitiés RL/2, qui sont représentées ici en dessous du convertisseur ADC. Elle est connectée entre une borne Vtop dite de sommet une borne Vbot dite de pied, la borne de pied étant reliée à la masse via un élément introduisant une tension variable, ici un transistor NPN T5, monté en émetteur commun : son collecteur est relié à la borne Vbot et son émetteur est relié à la masse.

Le montage est muni d'un montage générateur de polarisation intercalé entre la source de tension d'alimentation VCC et la borne de sommet Vtop ; il comprend, pour créer une tension :

- une première résistance Rmid dans laquelle passe le courant d'une source de courant de référence Ip0,
- une diode en série avec la résistance Rmid ; elle est constituée ici par un transistor NPN T4 monté en diode,
- un amplificateur opérationnel A1, dont l'entrée "+" est reliée à l'émetteur du transistor T4, dont la sortie est reliée à la grille d'un transistor PM à effet de champ à canal P dont le drain est connecté à la tension d'alimentation et dont la source est connectée à la borne Vtop ; le tout est monté en gain unité par suite du rebouclage de la source du transistor PM sur l'entrée "-" de l'amplificateur A1.

L'élément T5 introduisant une tension variable est commandé par la sortie d'un comparateur A2 qui compare une tension représentant la tension aux bornes de l'échelle de résistances, appliquée à son entrée "-", avec la tension aux bornes d'une deuxième résistance RFS, dans laquelle passe un courant de référence fourni par une source IFS. La résistance RFS est connectée d'un côté à la borne de sommet Vtop, et de l'autre à l'entrée "+" de l'amplificateur A2. La tension aux bornes de l'échelle de résistances est ici représentée par une tension Vmid, prélevée sur une prise au point milieu de l'échelle, entre les deux moitiés RL/2. Bien entendu, une autre position de la prise peut aussi être utilisée.

Les sources Ip0 et IFS sont éventuellement programmables, de façon à pouvoir régler respectivement le décalage et le gain du convertisseur. Toutefois il est avantageux que la source Ip0 et la source I3 soient aussi égales que possible pour assurer une parfaite compensation en température des tensions base-émetteur des transistors T3 et T4.

Avec la prise au milieu de l'échelle, la tension FS aux bornes de cette dernière, en supposant l'amplificateur A2 parfait (gain infini et impédance d'entrée nulle), est égale à :

$$FS = 2 \times RFS \times IFS$$

La valeur de la tension INAD dépend de la valeur des sources de courant de référence I1, I2, I3. En cas de dérive de ces sources de courant, on peut admettre en première approximation que toutes les sources, y compris Ip0 et IFS, dérivent de la même façon, et les amplitudes des tension FS et INAD resteront appariées.

En outre la composante continue de INAD est déterminée par la tension I2 × RC ajoutée à la chute de tension base-émetteur dans le transistor T3, et elle est compensée par la tension Ip0 × Rmid ajoutée à la chute de tension base-émetteur dans le transistor T4.

## Revendications

1. Circuit intégré, destiné à être alimenté entre une source de tension haute et une source de tension basse, muni de sources de courant de référence et contenant un convertisseur analogique/numérique muni d'une échelle de résistances connectée entre une borne dite de sommet une borne dite de pied pour fournir une série de tensions de référence, la borne de pied étant reliée à la source de tension basse via un élément à tension variable, **caractérisé en ce qu**'il est muni d'un montage générateur de polarisation intercalé entre la source de tension haute et la borne de sommet, et de moyens d'autorégulation pour commander l'élément à tension variable de façon à réguler la tension aux bornes de l'échelle de résistances.

2. Circuit intégré selon la revendication 1, **caractérisé en ce que** les moyens d'auto-régulation comprennent un comparateur pour comparer une tension représentant la tension aux bornes de l'échelle de résistances avec la tension sur une borne d'une résistance dont l'autre borne est connectée à la borne de sommet et qui est traversée par le courant d'une source de courant de référence.

3. Circuit intégré selon la revendication 2, **caractérisé en ce que** la dite tension représentant la tension aux bornes de l'échelle de résistances est prélevée en un point intermédiaire de l'échelle de résistances.

4. Circuit intégré selon la revendication 1, **caractérisé en ce que** le montage générateur de polarisation comprend une résistance reliée d'un côté à la source de tension haute et de l'autre côté à une source de courant de référence.

5. Circuit intégré selon la revendication 4, **caractérisé en ce que** le montage générateur de polarisation comprend une diode en série avec la résistance.

6. Circuit intégré selon la revendication 4, **caractérisé en ce que** le montage générateur de polarisation est muni en outre d'un amplificateur de sortie.

7. Circuit intégré selon la revendication 6, **caractérisé en ce que** le dit amplificateur de sortie comprend un amplificateur opérationnel suivi d'un transistor à effet de champ, le tout étant monté en gain unité.

EP 0 886 382 A1

**Office européen
des brevets**

**RAPPORT DE RECHERCHE EUROPEENNE**

Numéro de la demande

EP 98 20 1890

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP 0 382 217 A (NIPPON DENSO CO ;NIPPON SOKEN (JP)) 16 août 1990 <br> * le document en entier * <br> --- | 1 | H03M1/00 <br> G05F3/22 |
| A | US 5 389 929 A (NAYEBI MOHAMMAD R ET AL) 14 février 1995 <br> * colonne 2, ligne 3 - colonne 3, ligne 5 * <br> --- | 1 | |
| A | WO 93 09599 A (HARRIS CORP) 13 mai 1993 <br> * page 11, ligne 28 - page 13, ligne 8 * <br> ----- | 1 | |

DOMAINES TECHNIQUES RECHERCHES (Int.Cl.6)

H03M
G05F

Le présent rapport a été établi pour toutes les revendications

| Lieu de la recherche | Date d'achèvement de la recherche | Examinateur |
|---|---|---|
| LA HAYE | 9 septembre 1998 | Schobert, D |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)